# EUROPÄISCHE PATENTSCHRIFT

(11) **EP 1 175 816 B1**
(45) Veröffentlichungstag und Bekanntmachung des Hinweises auf die Patenterteilung: **21.07.2004**
(21) Anmeldenummer: 00940160.5
(22) Anmeldetag: 28.04.2000
(51) Int. Cl.: H05K 13/08

(54) **VERFAHREN UND VORRICHTUNG ZUM BESTÜCKEN VON SUBSTRATEN MIT BAUELEMENTEN**
METHOD AND DEVICE FOR PLACING COMPONENTS ON SUBSTRATES
PROCEDE ET DISPOSITIF POUR IMPLANTER DES COMPOSANTS SUR DES SUBSTRATS

(30) Priorität: 30.04.1999 DE 19919915
(43) Veröffentlichungstag der Anmeldung: 30.01.2002
(73) Patentinhaber: SIEMENS AKTIENGESELLSCHAFT, 80333 München (DE)
(72) Erfinder: STANZL, Harald, D-81476 München (DE)
(86) Internationale Anmeldenummer: PCT/DE2000/001350
(87) Internationale Veröffentlichungsnummer: WO 2000/067546

(56) Entgegenhaltungen:
- EP-A- 0 844 645
- WO-A-92/22827
- WO-A-98/37744
- US-A- 4 787 143

## Beschreibung

Die Erfindung bezieht sich auf ein Verfahren zur Herstellung einer elektrischen Baugruppe bestehend aus einem mit Bauelementen bestückten Substrat sowie eine Vorrichtung zur Herstellung einer elektrischen Baugruppe bestehend aus einem mit Bauelementen bestückten Substrat gemäß dem Oberbegriff des Patentanspruchs 9.

Aus WO 98/37744 ist eine Vorrichtung zum Herstellen von elektrischen Baugruppen (ein Bestückautomat) bekannt, bei der Bauelemente mittels eines Bestückkopfes aus Zuführeinheiten entnommen werden, zu einer vorgegebenen Position auf einem Substrat transportiert werden und dort auf das Substrat aufgesetzt werden.

Inwiefern ein Substrat in ordnungsgemäßen Zustand ist, wird in der Regel durch eine Markierung mit sogenannten Inkpunkten auf den Substraten erkannt. So können mehrere in einer Linie angeordnete Bestückautomaten, die ein Substrat mit unterschiedlichen Bauelemente bestücken, erkennen, daß ein Substrat im Lauf des Bestückprozesses als fehlerhaft markiert wurde. In der Linie nachfolgende Bestückautomaten werden dann diese bereits als fehlerhaft markierten Substrate nicht mehr bestücken und somit Bauelemente einsparen. Weitere Informationen über den Bestückablauf lassen sich derzeit nicht anhand der bestückten Substrate gewinnen.

Als allgemeine Speichereinheiten sind sogenannte Transponder bekannt, beispielsweise aus WO 92/22827. Diese Transponder sind in der Lage, ohne eigene Energieversorgung Informationen zu empfangen, diese Informationen abzuspeichern und sie wieder an eine Ausleseeinheit zu übertragen. Die Ubertragung der Informationen zur Speichereinheit und das Auslesen der Informationen erfolgt dabei drahtlos, im allgemeinen über Funk.

Eine Nutzung der Transponder für die Bestückung von Substraten mit Bauelementen ist nicht bekannt.

Es ist die Aufgabe der Erfindung, ein Verfahren und eine Vorrichtung zum Bestücken von Substraten mit Bauelementen sowie ein Substrat anzugeben, welche detailliertere Informationen über den Bestückablauf dem bestückten Substrat zuordnen und für nachfolgende Kontrollen zur Verfügung stellen.

Die Aufgabe wird erfindungsgemäß durch ein Verfahren der eingangs genannten Art mit den kennzeichnenden Merkmalen des Anspruchs 1, eine Vorrichtung der eingangs genannten Art mit den kennzeichnenden Merkmalen des Anspruchs 9 gelöst.

Erfindungsgemäß ist es vorgesehen, daß in oder an den zu bestückenden Substraten kontaktlose Datenspeichereinheiten (Transponder) angeordnet werden, in die von Kommunikationseinheiten Daten über den Bestückprozeß eingeschrieben werden, die der Steuereinrichtung des Bestückautomaten zugeordnet sind. Die dabei übermittelten und abgespeicherten Daten können zu beliebigen Zeiten während des Bestückablaufs oder danach ergänzt; gelöscht oder ausgelesen werden. Als Daten können dabei beispielsweise Informationen über die Hersteller der bestückten Bauelemente, über auf dem Substrat noch fehlende Bauelemente oder Ergebnisse von bereits im Bestückautomaten durchgeführte Inspektionen über die Güte des Bestückablaufs eingespeichert werden. Durch die Ausleseeinheit werden die Daten aus der Datenspeichereinheit wieder ausgelesen und werden dann beispielsweise für weitere Bestückprozesse oder für Fehleruntersuchungen ("retraceability") verwendet.

Besonders vorteilhaft gestaltet sich das Verfahren gemäß Anspruch 2, wenn die Datenspeichereinheit im Bestückautomaten auf das Substrat bestückt wird. Dadurch können nämlich in einfacher Weise alle herkömmlichen Substrate für das Verfahren verwendet werden, ohne das aufwendige neue Substratherstellungsverfahren entwickelt werden müssen.

In einer bevorzugten Ausgestaltung nach Anspruch 3 werden bei mehreren in einer Linie angeordneten Bestückautomaten, die auf einem Substrat jeweils unterschiedliche Bauelemente absetzen oder unterschiedliche Substratgebiete bestücken, die Daten der einzelnen jeweils in den unterschiedlichen Bestückautomaten ablaufenden Prozesse, nacheinander in der Datenspeichereinheit abgespeichert. Dadurch läßt sich später einfach nachvollziehen, auf welchem Bestückautomaten sich beispielsweise Fehlbestückungen häufen. Dieser Bestückautomat kann dann einfach repariert oder ausgewechselt werden.

Gemäß Anspruch 4 werden die bereits in der Datenspeichereinheit abgespeicherten Daten von in der Linie nachfolgenden Bestückautomaten ausgelesen und bei der Bestückung in diesen nachfolgenden Bestückautomaten berücksichtigt. Dadurch können eventuell entgegen des vorgeschriebenen Ablaufs noch fehlende Bauelemente nachbestückt werden, oder es werden als fehlerhaft erkannte Substrate nicht mehr mit - teilweise teuren - Bauelementen bestückt.

Eine noch bessere Kontrolle des Bestückablaufs wird erreicht, wenn gemäß der Ansprüche 5 und 14 das Substrat in Substratgebiete unterteilt ist und in oder an jedem Substratgebiet eine kontaktlose Datenspeichereinheit angeordnet wird. Dadurch lassen sich beispielsweise Fehler noch genauer eingrenzen.

Durch die vorteilhafte Ausgestaltung nach Anspruch 6 läßt sich auf einer bereits bestückten Leiterplatte herausfinden, welche Charge welches Herstellers fehlerhaft gewesen ist, so daß für nachfolgende Bestückungsvorgänge auf diese Bauelemente verzichtet wird.

Durch die Ausgestaltung nach Anspruch 7 wird in vorteilhafter Weise erreicht, daß noch fehlende Bauelemente beispielsweise durch in einer Linie nachfolgende Bestückautomaten nachbestückt werden. Dadurch muß nicht die ganze Linie abgeschaltet werden, wenn an einem Bestückautomaten ein Bauelement nicht mehr vorrätig ist.

Gemäß Anspruch 8 werden Inspektionsergebnisse abgespeichert, was den Vorteil hat, daß bei aufgetretenen Fehlern, die beispielsweise ein Sensor des in der Linie vorhergehenden Bestückautomaten erkannt hat, auf die weitere Bestückung dieses fehlerhaften Substrats verzichtet wird, oder versucht wird, den Fehler zu beseitigen.

Gemäß der Erfindung ist die Kommunikationseinheit am Bestückkopf angeordnet. Dadurch lassen sich bequem verschiedene Positionen auf dem Substrat anfahren und dort befindliche Datenspeichereinheiten beschreiben, falls die Reichweite der Datenübertragung recht klein ist.

In einer weiteren bevorzugten Ausgestaltung der Vorrichtung umfaßt die Kommunikationseinheit eine separate Auslese- und eine separate Schreibeinheit. Dadurch können die Datenspeichereinheiten von in den Bestückautomaten über eine Transporteinrichtung einfahrenden Substraten am Beginn des Transportweges ausgelesen werden, die Daten für den Bestückprozeß verwendet werden und am Ende des Transportweges werden die neuen Daten in die Datenspeichereinheit wieder eingespeichert.

In der Figuren der Zeichnung wird die Erfindung anhand von Ausführungsbeispielen näher erlautert. Dabei zeigen
Figur 1 eine schematische Seitenansicht eines Bestückautomaten mit einer am Bestückkopf angeordneten Kommunikationseinheit,
Figur 2 eine schematische Draufsicht auf zwei in einer Linie angeordneten Bestückautomaten mit jeweils am Anfang und am Ende des Transportwegs angeordneten Schreib- und Ausleseeinheiten und
Figur 3 eine schematische Draufsicht auf ein in mehrere Substratgebiete unterteiltes Substrat, wobei jedem Substratgebiet eine Datenspeichereinheit zugeordnet ist.

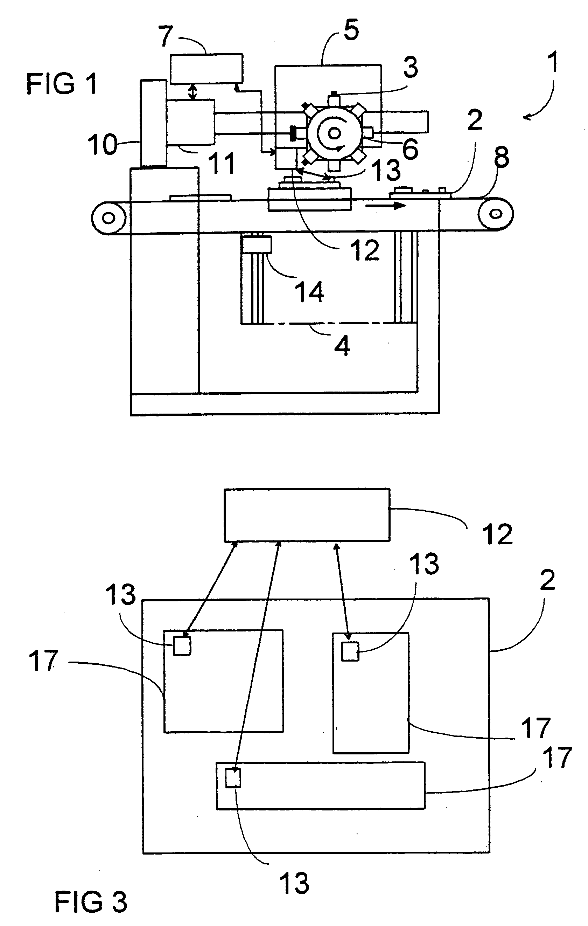

In Figur 1 ist in schematischer Seitenansicht ein Bestückautomat 1 dargestellt, in dem Substrate 2 mit Bauelementen 3 bestückt werden. Die Bauelemente 3 werden dabei aus Zuführeinheiten 4 entnommen und mittels eines Bestückkopfes 5, der mit Haltevorrichtungen 6, beispielsweise Saugpipetten, ausgestattet ist, in vorgegebenen Positionen auf das Substrat 2 abgesetzt. Die Steuerung des Bestückkopfes erfolgt über eine Steuereinrichtung 7, die sowohl eine Transportvorrichtung 8 zum Transport der Substrate 2 entlang eines Transportweges durch den Bestückautomaten als auch die Bewegung des Bestückkopfes 5 an einer an einem Rahmen 10 angeordneten Positioniereinrichtung 11 steuert. Die Positioniereinrichtung ist dabei beispielsweise durch ein System aus an in einer Richtung parallel zum Substrat beweglichen Schlitten und daran angeordneten Armen ausgebildet. Es'sind auch Bestückautomaten mit mehreren Bestückköpfen bekannt, für die die Erfindung ebenfalls eingesetzt werden kann. Die Steuereinheit 7 kommuniziert dabei mit einer am Bestückkopf angeordneten Kommunikationseinheit 12, die Daten zu einer auf dem Substrat 2 angeordneten kontaktlosen Datenspeichereinheit (Transponder) 13 überträgt oder aus dieser ausliest. Die Daten, die dabei von der Steuereinrichtung 7 an die Datenspeichereinheit 13 übertragen werden, sind beispielsweise Identifikationscodes der Hersteller der in diesem Bestückautomaten 1 auf das Substrat 2 bestuckten Bauelemente 3. Damit enthält das Substrat 2 Informationen über die Herkunft der darauf befindlichen Bauelemente 3, was im Fehlerfall für spätere Haftungsfragen von Interesse ist. Die Datenspeichereinheiten 13 können dabei bereist auf den noch unbestückten Substraten 2 vorhanden sein, oder sie werden im Bestückautomaten 1 aus einem Magazin 14 entnommen und mit Hilfe des Bestückkopfes 5 auf dem Substrat 2 abgesetzt und dabei - wie beispielsweise die Bauelemente 3 auch - durch einen Kleber gehalten. Auch vor dem Bestückprozeß bereits ins Material des Substrats 2 eingebrachte Datenspeichereinheiten 13 sind verwendbar.

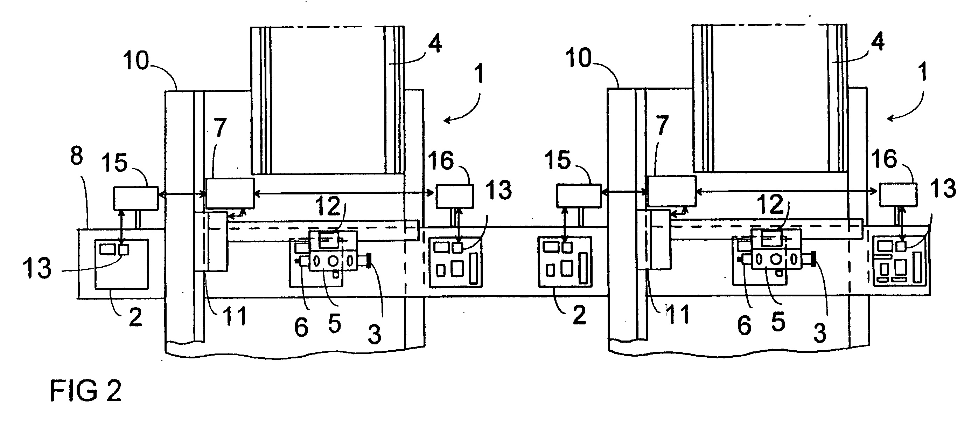

In einer weiteren Ausgestaltung nach Figur 2, die zwei im wesentlichen gleiche Bestückautomaten 1 wie in Figur 1 in Draufsicht zeigt, sind die Bestückautomaten 1 in einer Linie angeordnet. Jeweils am Anfang und am Ende des jeweiligen Transportweges weisen die Bestückautomaten 1 eine Ausleseeinheit 15 und eine Schreibeinheit 16 auf, die Teile der Kommunikationseinheit 12 sind. Durch die Kommunikation der Ausleseeinheit 15 der rechten, im Bestückablauf dem linken nachfolgenden, Bestückautomaten 1 mit der dazugehörigen Steuereinrichtung 7 werden von dem ersten, linken Bestückautomaten 1 in die Datenspeichereinheit 13 eingeschriebene Daten ausgelesen und für den Bestückablauf verwendet. Beispielsweise können auf diese Art Daten über noch fehlende Bauelemente 3 mitgeteilt werden, so daß bei im ersten Bestückautomaten fehlenden Bauelementen 3 nicht die ganze Linie steht, sondern diese Bauelemente 3 bei geeigneter Vorratshaltung von nachfolgenden Bestückautomaten bestückt werden. Außerdem lassen sich bereits im ersten Bestückautomaten bei Inspektionen erkannte Fehler an die nachfolgenden Bestückautomaten übertragen, die dann geeignete Maßnahmen starten können, wie eine Korrektur der Fehler oder auch eine Nichtbestückung des fehlerhaften Substrats, um teure Bauelemente einzusparen.

Das Auslesen der Datenspeichereinheiten 13 kann auch erst nach dem Durchlauf durch die gesamte Linie erfolgen, wenn beispielsweise keine direkte Anpassung des Bestückprozesses vorgesehen ist, sondern nur überprüft werden soll, ob am Ende auch alle gewünschten Bestückungen erfolgt sind.

Für eine genauere Fehlereingrenzung ist es geeignet, das Substrat 2 in mehrere Substratgebiete 17 einzuteilen, wie es in Figur 3 schematisch in Draufsicht dargestellt ist. Jedem Substratgebiet 17 ist eine eigene Datenspeichereinheit 13 zugeordnet, in der das jeweilige Substratgebiet 17 betreffende Daten abgespeichert sind, die jeweils separat durch eine Ausleseeinheit 12 auslesbar sind. Diese Ausleseeinheit 12 ist beispielsweise auch als selbständige Einheit ausgebildet, um vom Bestückautomaten unabhängig - beispielsweise bereits nach dem Einbau einer bestückten Leiterplatte als Substrat in ein elektrisches Gerät - Informationen über den Bestückablauf zu erhalten.

Durch die Erfindung ist somit die Möglichkeit eröffnet, genaue Daten über den Bestückablauf den einzelnen Substraten zuzuordnen, womit sowohl die Fehlererkennung als auch der Bestückablauf bei in Linie stehenden Bestückautomaten vereinfacht wird.

## Patentansprüche

1. Verfahren zur Herstellung einer elektrischen Baugruppe bestehend aus einem mit Bauelementen (3) bestückten Substrat (2), welches Daten des Bestückprozesses enthält, bei dem
- ein zu bestückendes Substrat (2) mit einer im oder am Substrat (2) angeordneten kontaktlosen Datenspeichereinheit (13) zur Verfügung gestellt wird,
- mindestens ein mittels einer Steuereinrichtung (7) gesteuerter Bestückkopf (5) die Bauelemente (3) zu einer vorgegebenen Position oberhalb des Substrates (2) transportiert und auf dem Substrat (2) in der vorgegebenen Position aufsetzt,
- die Steuereinrichtung (7) nach dem Aufsetzen der Bauelemente (3) über eine Kommunikationseinheit (12) Daten des Bestückprozesses in die Datenspeichereinheit (13) überträgt,
- die Daten in der Datenspeichereinheit (13) abgespeichert werden,
- die Daten von einer Ausleseeinheit (15) ausgelesen werden und
- eine der Ausleseeinheit (15) zugeordnete Kontrolleinheit (7) die ausgelesenen Daten für eine Auswertung des Bestückprozesses heranzieht.

2. Verfahren zur Herstellung eines mit Bauelementen (3) bestücken Substrats (2) nach Anspruch 1,
**dadurch gekennzeichnet,**
**daß** die Datenspeichereinheit (13) vom Bestückkopf (5) aus einem Magazin (14) entnommen wird und auf das Substrat (2) aufgesetzt wird.

3. Verfahren zur Herstellung eines mit Bauelementen (3) bestücken Substrats (2) nach einem der Ansprüche 1 oder 2,
**dadurch gekennzeichnet,**
**daß** bei mehreren nacheinander ablaufenden Bestückprozessen auf dem Substrat (2) die Daten jedes Bestückprozesses von den den jeweiligen Bestückprozessen zugeordneten Steuereinrichtungen (7) über die jeweiligen Kommunikationseinheiten (12) in die Datenspeichereinheit (13) übertragen und dort abgespeichert werden.

4. Verfahren zur Herstellung eines mit Bauelementen (3) bestücken Substrats (2) nach Anspruch 3,
**dadurch gekennzeichnet,**
**daß** vor dem Bestückprozeß die Daten aus einer bereits im oder am Substrat (2) angeordneten Datenspeichereinheit (13) von der Kommunikationseinheit (12) ausgelesen werden und von der Steuereinrichtung (7) für den Bestückprozeß verwendet werden.

5. Verfahren zur Herstellung eines mit Bauelementen (3) bestücken Substrats (2) nach einem der Ansprüche 1 bis 4,
**dadurch gekennzeichnet,**
**daß** das Substrat (2) in Substratgebiete (17) aufgeteilt wird, daß in oder an jedem Substratgebiet (17) eine eigene Datenspeichereinheit (13) angeordnet wird, die mit den Daten des Bestückprozesses beschrieben wird, die das jeweilige Substratgebiet (17) betreffen.

6. Verfahren zur Herstellung eines mit Bauelementen (3) bestücken Substrats (2) nach einem der Ansprüche 1 bis 5,
**dadurch gekennzeichnet,**
**daß** die Daten Identifikationscodes der während des jeweiligen Bestückprozesses bestückten Bauelemente (3) umfassen.

7. Verfahren zur Herstellung eines mit Bauelementen (3) bestücken Substrats (2) nach einem der Ansprüche 1 bis 6,
**dadurch gekennzeichnet,**
**daß** die Daten Informationen über auf dem Substrat (2) und/oder Substratgebiet (17) noch fehlende Bauelemente (3) umfassen.

8. Verfahren zur Herstellung eines mit Bauelementen (3) bestücken Substrats (2) nach einem der Ansprüche 1 bis 7,
**dadurch gekennzeichnet,**
**daß** die Daten Inspektionsergebnisse der während des jeweiligen Bestückprozesses bestückten Bauelemente (3) umfassen.

9. Vorrichtung zur Herstellung einer elektrischen Baugruppe bestehend aus einem mit Bauelementen (3) bestücken Substrat (2), welches Daten des Bestückprozesses enthält, mit mindestens einem Bestückkopf (5) zum Aufnehmen der Bauelemente (3), zum Transport der Bauelemente (3) an eine vorgegebene Position auf dem Substrat (2) und zum Absetzen der Bauelemente (3) auf dem Substrat (2) während eines Bestückprozesses,
mit einer Steuereinrichtung (7) zum Steuern des Bestückprozesses,
**dadurch gekennzeichnet,**
**daß** der Steuereinrichtung (7) eine am Bestückkopf (5) angeordnete Kommunikationseinheit (12) zugeordnet ist zum Einschreiben von Daten über den Bestückprozeß in eine kontaktlose Datenspeichereinheit (13) und/oder zum Auslesen von Daten über den Bestückprozeß aus der kontaktlosen Datenspeichereinheit (13), wobei die Datenspeichereinheit (13) im oder am Substrat (2) angeordnet ist.

## Revendications

1. Procédé de fabrication d'un sous-groupe électrique composé d'un substrat (2) revêtu de composants (3), lequel comporte des données du processus de revêtement, dans lequel
- un substrat à revêtir (2) est mis à disposition avec une unité de mémoire de données (13) sans contact disposée dans ou sur le substrat (2),
- au moins une tête de revêtement (5) commandée au moyen d'un dispositif de commande (7) transporte les composants (3) vers une position prédéfinie au-dessus du substrat (2) et les pose sur le substrat (2) dans la position prédéfinie,
- le dispositif de commande (7) après placement des composants (3) transmet par l'intermédiaire d'une unité de communication (12) des données du processus de revêtement dans l'unité de mémoire de données (13),
- les données sont enregistrées dans l'unité de mémoire de données (13),
- les données sont triées par une unité de tri (15) et
- une unité de commande (7) associée à l'unité de tri (15) se sert des données triées pour évaluer le processus de revêtement.

2. Procédé de fabrication d'un substrat (2) revêtu de composants (3) selon la revendication 1,
**caractérisé en ce que**
l'unité de mémoire de données (13) est extraite par la tête de revêtement (5) d'un chargeur (14) et est placée sur le substrat (2).

3. Procédé de fabrication d'un substrat (2) revêtu de composants (3) selon l'une des revendications 1 ou 2,
**caractérisé en ce**
**qu'**avec plusieurs processus de revêtement se déroulant les uns après les autres sur le substrat (2) les données de chaque processus de revêtement sont transmises par les dispositifs de commande (7) associés aux processus de revêtement respectifs par les unités de communication respectives (12) dans l'unité de mémoire de données (13) et y sont stockées.

4. Procédé de fabrication d'un substrat (2) revêtu de composants (3) selon la revendication 3,
**caractérisé en ce**
**qu'**avant le processus de revêtement les données sont sélectionnées dans une unité de mémoire de données (13) disposée dans ou sur le substrat (2) par l'unité de communication (12) et sont utilisées par le dispositif de commande (7) pour le processus de revêtement.

5. Procédé de fabrication d'un substrat (2) revêtu de composants (3) selon l'une des revendications 1 à 4,
**caractérisé en ce que**
le substrat (2) est divisé en zones de substrat (17), **en ce qu'**une unité de mémoire de données propre (13) est disposée dans ou sur chaque zone de substrat (17) laquelle unité est décrite avec les données du processus de revêtement, lesquelles concernent la zone de substrat respective (17).

6. Procédé de fabrication d'un substrat (2) revêtu de composants (3) selon l'une des revendications 1 à 5,
**caractérisé en ce que**
les données comprennent des codes d'identification des composants (3) revêtus pendant le processus de revêtement respectif.

7. Procédé de fabrication d'un substrat (2) revêtu de composants (3) selon l'une des revendications 1 à 6,
**caractérisé en ce que**
les données comprennent des informations sur des composants (3) encore manquants sur le substrat (2) et/ou la zone de substrat (17).

8. Procédé de fabrication d'un substrat (2) revêtu de composants (3) selon l'une des revendications 1 à 7,
**caractérisé en ce que**
les données comprennent des résultats d'inspection des composants (3) revêtus pendant le processus de revêtement respectif.

9. Dispositif de fabrication d'un sous-groupe électrique composé d'un substrat (2) revêtu de composants (3), lequel contient des données du processus de revêtement, avec au moins une tête de revêtement (5) pour prendre les composants (3), pour le transport des composants (3) à une position prédéfinie sur le substrat (2) et pour déposer les composants (3) sur le substrat (2) pendant un processus de revêtement,
avec un dispositif de commande (7) pour commander le processus de revêtement,
**caractérisé en ce**
**qu'**une unité de communication (12) agencée sur la tête de revêtement (5) est associée au dispositif de commande (7) pour inscrire des données concernant le processus de revêtement dans une unité de mémoire de données (13) sans contact et/ou pour sélectionner des données par le processus de revêtement dans l'unité de mémoire de données (13) sans contact, l'unité de mémoire de données (13) étant agencée dans ou sur le substrat (2).

## Claims

1. Method for the production of an electric subassembly comprising a substrate (2) assembled with components (3) which contains data about the assembly process, in which
- a substrate (2) for assembly with a contactless data storage unit (13) arranged in or on the substrate (2) is made available,
- at least one assembly head (5) controlled by means of a control unit (7) which transports components (3) to a predetermined position above the substrate (2) and deposits them on the substrate (2) in the predetermined position,
- the control unit (7) transfers assembly process data to the data storage unit (13) via a communication unit (12) after the placing of the components (3),
- the data is stored in the data storage unit (13),
- the data is read out from a readout unit (15)
and
- a control unit (7) assigned to the readout unit (15) extracts the readout data for an evaluation of the assembly process.

2. Method for the production of a substrate (2) assembled with components (3) according to Claim 1,
**characterized in that**
the data storage unit (13) is removed by the assembly head (5) from a magazine (14) and placed on the substrate (2).

3. Method for the production of a substrate (2) assembled with components (3) according to either Claim 1 or 2,
**characterized in that**
in the case of several consecutive assembly processes on the substrate (2), the data of each assembly process is transferred from the control units (7) assigned to the respective assembly processes via the respective communication units (12) to the data storage unit (13) and stored there.

4. Method for the production of a substrate (2) assembled with components (3) according to Claim 3,
**characterized in that**
before the assembly process the data is read out by the communication unit (12) from a data storage unit (13) already arranged in or on the substrate (2) and used by the control unit (7) for the assembly process.

5. Method for the production of a substrate (2) assembled with components (3) according to one of Claims 1 to 4,
**characterized in that**
the substrate (2) is divided up into substrate areas (17), that an own data storage unit (13) is arranged in or on each substrate area (17), and is written to by the data of the assembly process affecting the respective substrate area (17).

6. Method for the production of a substrate (2) assembled with components (3) according to one of Claims 1 to 5,
**characterized in that**
the data comprises identification codes of the components (3) assembled during the respective assembly process.

7. Method for the production of a substrate (2) assembled with components (3) according to one of Claims 1 to 6,
**characterized in that**
the data comprises information about components (3) still missing on the substrate (2) and/or substrate area (17).

8. Method for the production of a substrate (2) assembled with components (3) according to one of Claims 1 to 7,
**characterized in that**
the data comprises inspection results of the components (3) assembled during the respective assembly process.

9. Device for the production of an electric subassembly comprising a substrate (2) assembled with components (3), containing assembly process data, with at least one assembly head (5) for picking up the components (3), for transporting the components (3) to a predetermined position on the substrate (2) and for depositing the components (3) on the substrate (2) during an assembly process,
with a control unit (7) to control the assembly process,
**characterized in that**
the control unit (7) is assigned a communication unit (12) arranged on the assembly head (5) for writing data about the assembly process into a contactless data storage unit (13) and/or for reading out data about the assembly process from the contactless data storage unit (13), whereby the data storage unit (13) is arranged in or on the substrate (2).
